# EUROPEAN PATENT SPECIFICATION

(11) **EP 0 238 024 B1**
(45) Date of publication and mention of the grant of the patent: **24.11.1993**
(21) Application number: 87103807.1
(22) Date of filing: 16.03.1987
(51) Int. Cl.: H01L 21/285, C23C 16/14

(54) **Depositing tungsten on a semiconductor substrate**
Wolfram-Niederschlag auf einem Halbleitersubstrat
Déposition de tungstène sur un substrat à semi-conducteur

(30) Priority: 17.03.1986 JP 58753/86
(43) Date of publication of application: 23.09.1987
(73) Proprietor: FUJITSU LIMITED, Kawasaki-shi, Kanagawa 211 (JP)
(72) Inventor: Shioya, Yoshimi FUJITSU LIMITED, Nakahara-ku Kawasaki-shi Kanagawa 211 (JP); Oyama, Yasushi FUJITSU LIMITED, Nakahara-ku Kawasaki-shi Kanagawa 211 (JP); Tsuzuki, Norihisa FUJITSU LIMITED, Nakahara-ku Kawasaki-shi Kanagawa 211 (JP); Maeda, Mamoru FUJITSU LIMITED, Nakahara-ku Kawasaki-shi Kanagawa 211 (JP); Ichikawa, Masaaki FUJITSU LIMITED, Nakahara-ku Kawasaki-shi Kanagawa 211 (JP); Mieno, Fumitake FUJITSU LIMITED, Nakahara-ku Kawasaki-shi Kanagawa 211 (JP); Inoue, Shin-ichi FUJITSU LIMITED, Nakahara-ku Kawasaki-shi Kanagawa 211 (JP); Uo-Ochi, Yasuo FUJITSU LIMITED, Nakahara-ku Kawasaki-shi Kanagawa 211 (JP); Tabuchi, Akira FUJITSU LIMITED, Nakahara-ku Kawasaki-shi Kanagawa 211 (JP); Tsukune, Atsuhiro FUJITSU LIMITED, Nakahara-ku Kawasaki-shi Kanagawa 211 (JP); Watanabe, Takuya FUJITSU LIMITED, Nakahara-ku Kawasaki-shi Kanagawa 211 (JP); Ohba, Takayuki FUJITSU LIMITED, Nakahara-ku Kawasaki-shi Kanagawa 211 (JP)
(74) Representative: Sunderland, James Harry

(56) References cited:
- EP-A- 0 124 181
- US-A- 4 617 087
- JAPANESE JOURNAL OF APPLIED PHYSICS SUPPLEMENTS, supplements 15th conference on Solid State Devices and Materials, 1983, pages 225-228, Tokyo, Japan ; T. MORIYA et al. : "A New Encroachment-Free Tungsten CVD Process with Superior Selectivity"
- PROCEEDINGS SECOND INTERNATIONAL IEEE VLSI MULTILEVEL INTERCONNECTION CONFERENCE, 25-26 June 1985, pages 343-349 ; R.H. WILSON et al. : "Highly selective, high rate W deposition for via filling"
- PROCEEDINGS SECOND INTERNATIONAL IEEE VLSI MULTILEVEL INTERCONNECTION CONFERENCE, 25-26 June 1985, pages 350-356 ; G.C. SMITH et al. : "CVD tungsten contact plugs by in situ deposition and etchback"
- THIN SOLID FILMS, vol. 52, no. 2, July 1978, pages 181-194 ; C. E. MOROSANU et al. : "Kinetics and properties of chemically vapour-deposited tungsten films on silicon substrates"
- IBM TECHNICAL DISCLOSURE BULLETIN, vol. 29, no. 8, January 1987, pages 3403, 3404 ; "Contact stud fabrication process using dual ion-beam deposition and etch"

## Description

The present invention relates to the deposition of tungsten upon a semiconductor substrate.

In semiconductor LSIs (Large Scale Integrated Circuits), polycrystalline silicon has been widely employed for fabricating electrodes and/or electrical wiring. However, there is a limit to the degree to which the electrical resistance of polycrystalline silicon can be reduced, because it is a semiconductor. Therefore, a refractory metal, such as tungsten, or its silicide, has been employed in place of the polycrystalline silicon.

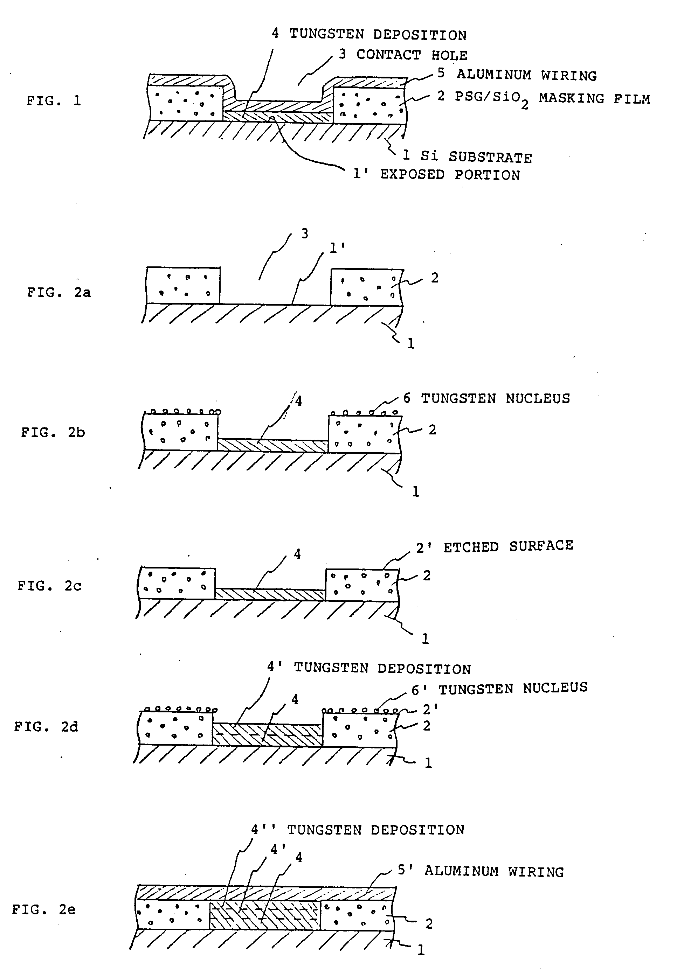

Fabrication of a tungsten electrode or tungsten wiring will be explained below with reference to Fig. 1, which is a schematic cross-sectional view.

The whole surface of a silicon semiconductor substrate 1 is coated with a masking film of a phospho-silicate glass (referred to hereinafter as PSG) or silicon dioxide (referred to hereinafter as SiO₂) generally as much as approximately 1µm thick. The masking film 2 is patterned using a lithography technique so that an opening, such as a contact hole 3, is provided at a portion of the substrate on which tungsten is to be deposited, to expose a portion 1ʹ of the substrate. Next, the substrate 1, having the masking film 2 thereon, is loaded into a CVD (Chemical Vapour Deposition) apparatus. A reaction gas, i.e. a mixture of tungsten hexafluoride (referred to hereinafter as WF₆) gas and a hydrogen (referred to hereinafter as H₂) gas, is fed into the apparatus, and gas pressure is reduced to 13 to 67 Pa (0.1 to 0.5 Torr), and then the substrate 1 having the masking film 2 thereon is heated.

Chemical reactions given by the following formulae take place.

2 WF₆ + 3 Si = 2 W + 3 SiF₄ (1)

WF₆ + 3 H₂ = W + 6 HF (2)

The exposed silicon of the substrate 1 is active to reduce the WF₆ and produces SiF₄ and W (tungsten). The produced tungsten is deposited upon the surface of the exposed portion 1ʹ of the silicon substrate 1. This reducing reaction (1) does not take place on the SiO₂ of the masking film 2, therefore little tungsten is deposited on the masking film 2. Thus, selective deposition of the tungsten is performed. However, when the deposited tungsten forms a film on the exposed portion 1ʹ of the silicon substrate 1, the tungsten film so formed prevents the silicon substrate from further reacting with the WF₆ gas. Thus, tungsten deposition cannot proceed beyond a thickness of deposited tungsten of approximately 100 nm (1000 Angstroms). Therefore, in order to maintain deposition of tungsten, H₂ gas is added in the WF₆ gas. The chemical reaction involved is given by formula (2). WF₆ is reduced to provide HF (hydrofluoric acid) and W (tungsten). The reaction (2) not only produces tungsten additionally on the previously deposited tungsten but also newly forms tungsten nucleii on the surface of the masking film 2, and the nucleii keep on growing to form a tungsten film. If the tungsten nucleii form a film, the tungsten film imperils the function of the masking film, i.e. electrical isolation, and the film is not easily removed. Therefore, the reaction (2) must be discontinued before tungsten film is formed on the masking film 2. This means that tungsten film 4 formed on the exposed silicon substrate 1ʹ cannot be deposited to a thickness greater than 300 nm (3000 Angstroms) (typically 200nm (2000 Angstroms)). This thickness is sufficient for the deposited tungsten 4 to be an electrical conductor. However, the big difference between the heights of the surfaces of the masking film 2 (approximately 1µm) and the deposited tungsten 4 (approximately 200 nm (2000 Angstroms)) causes problems in later processing for fabricating a reliably continuous aluminium wiring 5 on those surfaces for connecting the deposited tungsten, i.e. an electrode, to an external connection. In other words, the accuracy of the photolithography of the aluminium film 5 deposited on the non-flat surface is, of course, deteriorated, and also the sharp edge of the masking film 2 may cause discontinuity of the aluminium deposition. This problem becomes impermissibly serious for fabricating VLSIs (Very Large Scale Integrated Circuits) of sub-micron order. Therefore, there is a need for a method of providing a thick tungsten film whose surface can form a substantially flat surface together with the surface of the masking film.

The Proceedings of the Second (1985) International IEEE VLSI Multilevel Interconnection Conference, contain a report by Wilson et al., at pages 343 to 349, which concerns the selective deposition of tungsten using low pressure chemical vapour deposition reacting tungsten hexafluoride and hydrogen, to fill contact holes.

Those proceedings also contain a report by Smith, at pages 350 to 356, which concerns the use of non-selective CVD tungsten deposition (with subsequent etchback) to fill contact holes.

EP-A-0 124 181 discloses the formation of a tungsten layer as an etching stop. The tungsten etching stop layer is formed in a window on a conductive track of aluminium or doped polycrystalline silicon. A selective tungsten deposition process is employed using a chemical vapour deposition method using an atmosphere of tungsten hexafluoride and hydrogen. It is disclosed that tungsten deposited on exposed insulating layers (of silicon dioxide or silicon nitride) around the conductive track can be removed by cleaning using hydrogen peroxide.

According to the present invention there is provided a method of selectively depositing tungsten upon a semiconductor substrate, comprising the steps of :-
forming a patterned mask, of a phosphosilicate glass or of silicon dioxide, on the substrate;
depositing tungsten upon a part of the substrate not covered by the patterned mask using a chemical vapour deposition method, using an atmosphere which contains tungsten hexafluoride gas and hydrogen gas;
removing tungsten deposited upon the surface of the patterned mask by heating the patterned mask and dry etching using an atmosphere which contains nitrogen trifluoride gas and hydrogen gas; and
depositing further tungsten, after the removing step, upon the tungsten deposited upon the substrate.

An embodiment of the present invention can provide a method of selectively depositing thick tungsten on a silicon semiconductor substrate, such that the surface of the deposited tungsten and the surface of a masking film can be level with each other, in order to allow an accurate and reliable patterning of aluminium film thereon.

In an embodiment of the present invention tungsten is selectively deposited by the use of a CVD method on an exposed portion of a semiconductor substrate through an opening in a masking film of phospho-silicate glass (PSG) or silicon dioxide (SiO₂) coated on the silicon substrate. At the same time, some tungsten is deposited also on the masking film, though the rate of deposition is slow. Before a tungsten film is formed on the masking film, the tungsten deposited on the masking film is removed. The removal of tungsten from the masking film is carried out by heating the substrate and dry etching in an atmosphere which contains nitrogen trifluoride (NF₃) gas and hydrogen gas. Next, a further deposition of tungsten, upon the previously deposited tungsten on the substrate, is provided by repeating the previous deposition process. By repetition of the above-described processes, i.e. deposition and removal, a tungsten deposition (on the substrate) can reach a thickness of 1µm, which is substantially the same as that of the masking film. Thus, the surfaces of the deposited tungsten and the masking film form a practically flat common surface. Therefore, in a later process, an aluminium film can be deposited and patterned on this flat surface accurately and reliably, and thus fabrication of VLSIs of sub-micron order can be achieved.

Reference is made, by way of example, to the accompanying drawings, in which:-
Fig. 1 is a schematic cross-sectional view for assistance in explaining the deposition of tungsten on a semiconductor substrate by a previous method; and
Figs. 2a to 2e are schematic cross-sectional views illustrating steps in the deposition of tungsten according to the present invention.

Fig. 2a shows a semiconductor substrate 1, which would in general be of silicon containing some dopants, as is widely known, and a masking film 2, which would be coated on the whole surface of the substrate 1. The masking film 2 is generally made of PSG or SiO₂, and approximately 1µm thick. An opening, i.e. a contact hole 3, is made by patterning the masking film 2 using a lithography technique. So, a portion 1ʹ of the substrate 1 at the bottom of the contact hole 3 is exposed. The substrate 1 coated with the masking film 2 is loaded into a CVD apparatus and CVD-processed according to the following conditions:

| | |
|---|---|
| WF₆ supplied at a flow rate of | 100 cc/min. |
| H₂ supplied at a flow rate of | 6 litre/min. |
| Gas pressure | 40 to 67 Pa (0.3 to 0.5 Torr) |
| Temperature of the substrate | 325°C. |

Chemical reactions taking place therein are the same as those indicated by formulae (1) and (2) above.

The SiO₂ of the masking film is etched out by the produced HF, so the surface of the film is caused to be rough. Microscopically sharp edges of the rough surface are apt to have tungsten nucleii grow thereon. Processing is continued until an island structure, which consists of many nucleii 6 of tungsten, is produced and seen on the surface of the masking film 2, as illustrated in Fig. 2b. The CVD processing is then stopped. At this time, 200 to 300 nm (2000 to 3000 Angstroms) thickness of tungsten 4 has been deposited on the exposed surface 1ʹ of the silicon substrate 1. It takes approximately 30 minutes for these reactions. If CVD deposition were to continue after the island structure is produced, the undesired tungsten nucleii 6 on the masking film 2 would grow quickly, and the selectivity of deposition would be reduced.

Next, the tungsten nucleii 6 on the masking film 2 are removed, as illustrated in Fig. 2c. The removal may be carried out by one of the following methods, the first and second method described below not being in accordance with the present invention.

The first method involves the use of hydrogen gas. When the above-described tungsten deposition process is stopped a hydrogen gas is fed into the CVD apparatus with the loaded substrate 1 kept as it was. The conditions are as follows:

| | |
|---|---|
| H₂ gas supply | 400 cc/min. |
| Temperature of the substrate | 325°C |
| Gas pressure | 40 to 67 Pa (0.3 to 0.5 Torr). |

The H₂ gas reacts with a fluorine atom produced from the WF₆ in the previous deposition process and still remaining in the CVD apparatus, to produce HF gas in the apparatus. This HF gas etches the SiO₂ content in the surface of the masking film 2 which is supporting the tungsten nucleii 6 thereon; thus the tungsten nucleii 6 are removed. It takes typically 10 minutes for this processing. This method is an efficient method because the same apparatus can be continuously used for the deposition and removal of the tungsten without a break and with no need to open the apparatus and take out the substrate.

The second method of removing the tungsten nucleii 6 involves wet etching with HF solution. The etchant(s) used and the processing involved can be chosen from the following:
a. Washing in a dilute HF solution and then in water;
b. Washing in a H₂O₂ (hydrogen peroxide) solution, then in a dilute HF solution, then in water;
c. Washing in a solution of NH₄OH (ammonia) + H₂O₂, then in a dilute HF solution, and then in water.

Both the H₂O₂ and NH₄OH + H₂O₂ are active to etch the tungsten nucleii. The HF acts in the same way as described above.

According to the present invention, a third method of removing the tungsten nucleii 6 is employed, which involves dry etching in a NF₃ + H₂ gas in the CVD apparatus following the tungsten deposition process. The conditions are as follows:

| | |
|---|---|
| NF₃ gas supply | 100 cc/min. |
| H₂ gas supply | 400 cc/min. |
| Gas pressure | 13 to 27 Pa (0.1 to 0.2 Torr) |
| Temperature of the substrate | 400 to 500°C. |

HF gas is then produced as shown below

2 NF₃ + 3 H₂ = N₂ + 6 HF.

The produced HF gas acts in the same way as described above. In the process for tungsten nucleii removal, the masking film may be etched by a few tenths of nanometers.

After removing the undesirably deposited tungsten nucleii 6 on the masking film 2, the same deposition processing as that carried out previously is carried out again. Thus a tungsten film 4' is additionally deposited on the previously deposited film 4. Upon the etched surface 2' of the masking film 2, new tungsten nucleii 6' are undesirably deposited again in the same way as in the first deposition process. This state is illustrated in Fig.2d. Then, the tungsten nucleii 6' on the masking film 2 are again removed, by removal processing as described above. After repeating the processes of tungsten depositon and removal several times, for example three times, the height of tungsten deposition 4+4'+4"... in the contact hole 3 becomes substantially the same as the height of the masking film 2, and thus a flat surface, as shown in Fig. 2e, is provided. A deposition thickness of as much as 1µm can be achieved after proper repetition of the processings.

An aluminium film 5' (Fig. 2e) is deposited on the practically flat surface of the deposited tungsten 4+4'+4''... and the masking film 2, and then patterned, for example by a sputtering and a lithography technique, for connecting the deposited tungsten to other parts of a semi conductor device or to an external connection. Owing to the good flatness of the surface on which the aluminium wiring is patterned, the wiring is fabricated accurately and reliably. Thus, embodiments of the present invention can contribute to the achievement of VLSIs of sub-micron order.

Although, in the description of embodiments of the present invention given above, reference is made to a contact hole, in which tungsten is deposited as an electrode, it will be apparent that embodiments of the invention can be applied to the deposition of tungsten for wirings as well.

The method of the present invention may be implemented in a method of selectively depositing tungsten upon a silicon semiconductor substrate, on which a masking film of PSG or SiO₂ is coated and patterned to provide an opening for forming an electrode or wiring therein. On a portion of the substrate in the opening, approximately 200 nm (2000 Angstroms) thickness of tungsten is deposited by a CVD method, in which tungsten hexafluoride gas and hydrogen gas are used and the substrate is heated. As a result of this processing, some tungsten nucleii are deposited on the surface of the masking film as well. Before the nucleii form a film, the deposition processing is discontinued and a dry etching carried out, thus to remove the tungsten nucleii thereon. The above-described processings, i.e. deposition and removal of tungsten, are repeated several times until the heights of the deposited tungsten and the masking film become practically equal, forming a flat surface. Aluminium film is deposited on the flat surface and patterned by lithography. Thus, the flat aluminium deposition allows the fabrication of accurate and reliable wiring, which is important for achievement of VLSIs of sub-micron order.

## Claims

1. A method of selectively depositing tungsten upon a semiconductor substrate (1), comprising the steps of:-
forming a patterned mask (2), of a phosphosilicate glass or of silicon dioxide, on the substrate;
depositing tungsten (4) upon a part of the substrate (1) not covered by the patterned mask (2) using a chemical vapour deposition method, using an atmosphere which contains tungsten hexafluoride gas and hydrogen gas;
removing tungsten (6) deposited upon the surface of the patterned mask (2) by heating the patterned mask and dry etching using an atmosphere which contains nitrogen trifluoride gas and hydrogen gas; and
depositing further tungsten (4'), after the removing step, upon the tungsten (4) deposited upon the substrate (1).

## Patentansprüche

1. Verfahren zum selektiven Abscheiden von Wolfram auf einem Halbleitersubstrat (1), umfassend die Schritte:
Erzeugen einer Strukturmaske (2) aus Phosphorsilikatglas oder Siliciumdioxid auf dem Substrat;
Abscheiden von Wolfram (4) auf einem Teil des Substrats (1), das nicht von der Strukturmaske abgedeckt ist, mit einem chemischen Dampfabscheidungsverfahren aus einer Atmosphäre, die gasförmiges Wolframhexafluorid und Wasserstoffgas enthält;
Entfernen von Wolfram (6), das sich auf der Strukturmaske (2) abgeschieden hat, durch Erhitzen der Strukturmaske und Trockenätzen in einer Atmosphäre, die gasförmiges Stickstofftrifluorid und Wasserstoffgas enthält; und - nach dem Entfernungsschritt -
Abscheiden weiteren Wolframs (4') auf das Wolfram (4), das auf dem Substrat (1) abgeschiedenen wurde.

## Revendications

1. Procédé de dépôt sélectif de tungstène sur un substrat semiconducteur (1), comprenant les étapes de :
formation d'un masque conformé (2) en verre de phosphosilicate ou en dioxyde de silicium sur le substrat ;
dépôt de tungstène (4) sur une partie du substrat (1) non recouverte par le masque conformé (2) en utilisant un procédé de dépôt chimique en phase vapeur qui utilise une atmosphère qui contient du gaz hexafluorure de tungstène et du gaz hydrogène ;
enlèvement du tungstène (6) déposé sur la surface du masque conformé (2) en chauffant le masque conformé et en le gravant à sec en utilisant une atmosphère qui contient du gaz trifluorure d'azote et du gaz hydrogène ; et
dépôt d'un autre tungstène (4'), après l'étape d'enlèvement, sur le tungstène (4) déposé sur le substrat (1).
